# EUROPEAN PATENT SPECIFICATION

(11) **EP 0 605 791 B1**
(45) Date of publication and mention of the grant of the patent: **31.01.1996**
(21) Application number: 93119289.2
(22) Date of filing: 30.11.1993
(51) Int. Cl.: H01L 21/00

(54) **Apparatus for forming a film**
Apparat um einen film zu bauen
Appareil pour former un film

(30) Priority: 30.11.1992 JP 320504/92
(43) Date of publication of application: 13.07.1994
(73) Proprietor: CANON SALES CO., INC., Minato-ku, Tokyo 108 (JP); ALCAN-TECH CO., INC., Tokyo 108 (JP); SEMICONDUCTOR PROCESS LABORATORY CO., LTD., Minato-ku, Tokyo 108 (JP)
(72) Inventor: Maeda, Kazuo, c/o Semicond. Process Lab.Co.Ltd, Tokyo (JP); Ohira, Kouichi, c/o Semicond. Process Lab.Co.Ltd, Tokyo (JP); Chino, Hiroshi, c/o Semicond. Process Lab.Co.Ltd, Tokyo (JP)
(74) Representative: Marx, Lothar, Dr.

(56) References cited:
- EP-A- 0 526 644

## Description

### BACKGROUND OF THE INVENTION

### 1. Field of the Invention

The present invention relates to an apparatus for forming a film, particularly to an apparatus for forming a film by the CVD method.

### 2. Description of the Related Art

There are various types of CVD apparatus for formng a film. For every CVD apparatus, the chemical reaction of a reaction gas is used for forming a film, therefore, reaction products stick to the gas discharge surface of a gas distributor. In this case, when the reaction products come off and stick to a wafer again as particles, the wafer is contaminated. To prevent the particles from sticking onto the wafer, it is necessary to regularly clean the gas discharge surface of the gas distributor of the CVD apparatus.

For a plasma assisted CVD apparatus of the various types of CVD apparatus, as it is capable of reducing the pressure in a chamber, it is capable of introducing an etching gas into the.chamber having reduced the pressure.

Therefore, even if reaction products stick to the gas discharge surface of a gas distributor, it is possible to easily remove the reaction products from the gas discharge surface by the introduced etching gas. This method is called in-situ cleaning and practically used.

For an atmospheric pressure CVD apparatus using, for example, a reaction gas such as SiH₄-O₂ mixed gas or TEOS-O₃ mixed gas , however, because the apparatus does not normally have a constitution capable of reducing the pressure in a chamber, in the case that reaction products stick to a gas discharge surface in the form of powdered particles, it is impossible to perform the in-situ cleaning dissimilar to the plasma assisted CVD apparatus. In such a case, the reaction products are physically removed by a cleaner or the like, or they are chemically removed by exposing a gas discharge surface to chemicals such as hydrofluoric acid (HF) in the state of stopping the operation of the CVD apparatus and opening the chamber.

Therefore, for the atmospheric pressure CVD apparatus, cleaning requires a lot of time and labor and this decreases the working ratio of the apparatus. Moreover, when the quantity of accumulated reaction products extremely increases, there arises such a problem that it is difficult to remove them.

EP-A-526644 corresponding to WO 92 15/115 discloses a semiconductor manufacturing equipment for forming a film on a wafer through the CVD method. This apparatus comprises a gas distributor having a horizontal gas discharge surface from which a reaction gas for forming a film on a substrate is discharged; a wafer holder having a wafer mounting surface facing the gas discharge surface; a cleaner having a suction port and a brush formed at the entrance of the suction port; and a rotary vertical shaft for supporting the cleaner to reciprocate the cleaner between the gas discharge surface and a rest position of the cleaner.

Because the cleaners are in mechanical connection with the wafer holder in the case of detaching the wafer holder for repair purposes it is also necessary to detach the cleaners from the wafer holder which needs extra labour so that the efficiency of this apparatus is decreased.

### SUMMARY OF THE INVENTION

It is an object of the present invention to provide an apparatus for forming a film allowing reaction products to be easily removed from a gas discharge surface without decreasing the efficiency of the apparatus.

This object is solved by the features of claim 1

The apparatus for forming a film of the present invention has a gas distributor having a horizontal gas discharge surface from which a reaction gas for forming a film on a substrate is discharged; a wafer holder having a wafer mounting surface facing the gas discharge surface; a cleaner having a suction port and a brush formed at the entrance of the suction port; a rotary vertical shaft for supporting the cleaner to reciprocate the cleaner between the gas discharge surface and a rest position, so that the brush of the cleaner can contact the gas discharge surface; a moving means for moving the wafer holder or gas distributor upwardly or downwardly, so that the wafer holder approaches the gas discharge surface when forming a film, and is kept away from the gas discharge surface when cleaning the gas discharge surface upon moving the cleaner on the gas discharge surface.

Preferred embodiments of the present invention are given by the dependent claims.

Therefore, before or after forming a film, by brushing the gas discharge surface with the brush while exhausting gas through the suction port by exhauster contacted to it, it is possible to make dust come off from the gas discharge surface and simultaneously draw in dust having come off. Thereby, it is possible to keep the gas discharge surface clean, prevent dust from scattering in a chamber, and thus keep higher cleanliness in the chamber.

The cleaner is provided at a mechanical section which is separated from a wafer holder and gas distributor. Therefore, it is possible to leave the cleaner as it is when detaching the wafer holder or gas distributor for cleaning or repair and, on the contrary, it is possible to leave the wafer holder and gas distributor as they are when detaching the cleaner. Therefore, a maintenance of the apparatus can easily be performed.

Moreover, because the cleaner is provided in the chamber, it is possible to easily remove dust from the chamber without opening the chamber. Therefore, because it is unnecessary to stop the apparatus to clean the chamber unlike the existing way, it is possible to prevent the working ratio of the apparatus from decreasing.

Furthermore, because the cleaner is set in the chamber in which the gas distributor and wafer holder supported by a rotary shaft are provided, it is possible to provide such an automated and continuous type of a CVD apparatus capable of keeping the chamber clean at all times.

Furthermore, as the wafer holder is supported by the rotary shaft and the rotary shaft of the cleaner is secured to the wafer holder, it is possible to move the cleaner onto every gas discharge surface of the gas distributor by rotating the wafer holder.

### BRIEF DESCRIPTION OF THE DRAWING

Fig. 1 A to Fig. 1 C are illustrations of the cleaner used for the CVD apparatus of an embodiment of the present invention, in which Fig. 1 A is a top view showing a state in which the cleaner has come on a gas discharge surface of a gas distributor by being rotated, Fig. 1 B is a side view showing a state in which a film is formed on a wafer, and Fig. 1 C is a side view showing a state in which the cleaner has come on a gas discharge surface by being rotated to clean the gas discharge surface;
Fig. 2 is a side view showing the constitution of a CVD apparatus having the cleaner of the embodiment of the present invention;
Fig. 3 is a top view showing the detailed constitution of the wafer holder of the CVD apparatus of the embodiment of the present invention;
Fig. 4 is a top view showing the detailed constitutions of the gas distributor and cleaner of the CVD apparatus of the embodiment of the present invention;
Fig. 5 is a side view showing a method for operating the CVD apparatus of the embodiment of the present invention; and

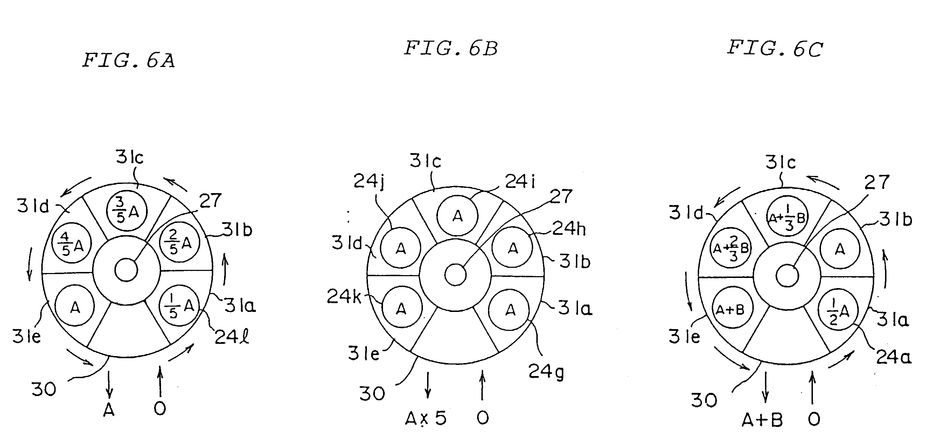

Fig. 6 A to Fig. 6 C are typical top views showing a semiconductor device manufacturing method using the CVD apparatus of the embodiment of the present invention, in which Fig. 6 A is a top view showing a state where a film is formed on a wafer while a wafer holder takes a turn around a rotary shaft, Fig. 6 B is a top view showing a state where a wafer is mounted on every susceptor to form a film simultaneously on every wafer by using one type of reaction gas, and Fig. 6 C is a top view showing a state where a multilayer film comprising two types of films is formed on one wafer by using two types of reaction gases.

### DESCRIPTION OF THE PREFERRED EMBODIMENT

### (1) Constitution of CVD apparatus

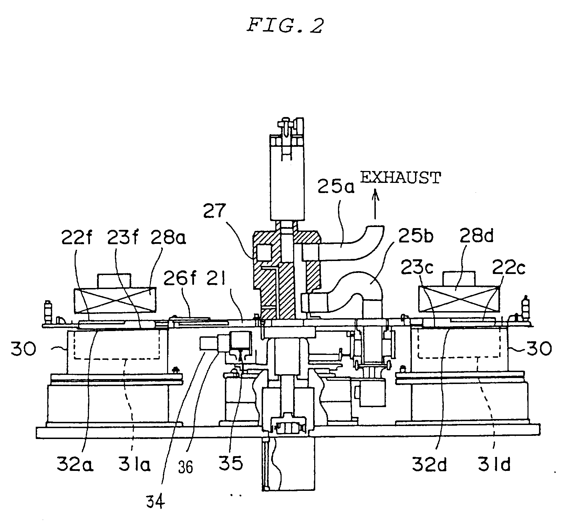

The constitution of the CVD apparatus of an embodiment of the present invention is described below by referring to Fig. 2 to Fig. 4.

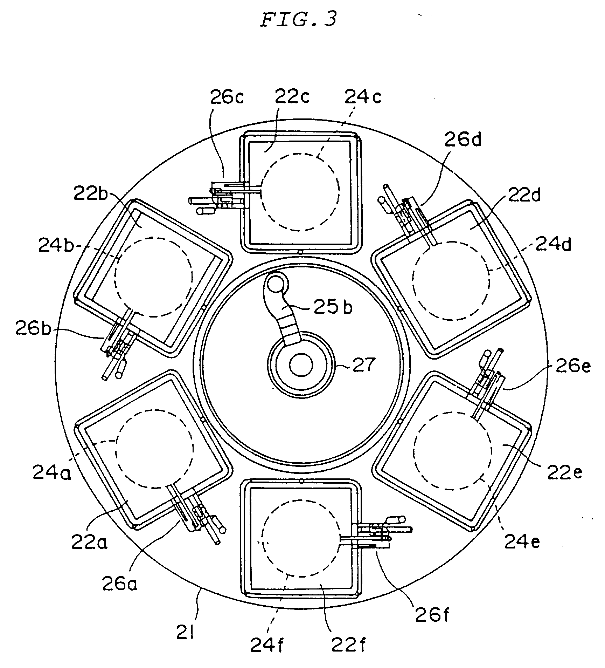

In Fig. 2 and Fig. 3, symbol 21 is a discoid wafer holder. Six detachable susceptors 22a to 22f are set along the circumference of the disk at equal intervals. The susceptors 22a to 22f are made of stainless steel and have a large heat capacity so that a temperature of each of the susceptors 22a to 22f raised by heaters does not easily lower. Wafer mounting surfaces 23a to 23f of the susceptors 22a to 22f are turned downward so that wafers 24a to 24f mounted on the wafer mounting surfaces 23a to 23f face gas discharge surfaces 32a to 32e of a gas distributor 30.

Moreover, a pipe 25b is connected to the wafer holder 21 so that the wafers 24a to 24f are secured to the wafer mounting surfaces 23a to 23f by suction through exhausting gas through the pipe 25b and gas exhaust/introduction port 25a and . On the contrary, a nitrogen gas is introduced through the pipe 25b and gas exhaust/introduction port 25a to take the wafers away from the wafer mounting surfaces 23a to 23f by blowout of nitrogen gas.

A not-illustrated oscillation unit is provided on the susceptors 22a to 22f respectively to rotate or linearly move each of them in the radial direction around a shaft vertical to each of the wafer mounting surfaces 23a to 23f.

Symbols 26a to 26f are thermocouples (temperature measuring means) detachable from the susceptors 22a to 22f. Fig. 2 and Fig. 3 shows a state where the thermocouples 26a to 26f are mounted. Under this state, temperatures of the wafers 24a to 24f are measured.

Symbol 27 is a rotary shaft by which the wafer holder 21 is supported. The wafer holder 21 rotates around the rotary shaft 27 on a moving surface put between gas dischargers 31a to 31e and heaters 28a to 28f in the state of holding the wafers 24a to 24f.

Moreover, the rotary shaft 27 moves downward or upward and the wafer holder 21 also moves downward or upward according to the vertical movement of the rotary shaft 27. When cleaning any of the gas dischrge surface 32a to 32e, the wafer holder 21 is kept away from the gas distributor 30 by moving the wafer holder 21 upward so that a space is secured between the wafer holder 21 and gas distributor 30. Thereby, the cleaner 34 can be moved in the space.

On the other hand, the holder 21 is made to approach the gas discherge surface by moving the wafer holder 21 downward.

Symbols 28a and 28d are heaters (heating instruments) facing the susceptors 22c and 22f of the wafer holder 21. However, Fig. 2 shows only the heaters 28a and 28d among those facing the susceptors 22a to 22f. The heaters 28a to 28f are separated from each other so that they can independently supply electric power. They heat the susceptors 22a to 22f from the opposite side of the wafer mounting surfaces 23a to 23f by heat radiation and heat conduction and the temperature of the susceptors 22a to 22f is raised so that the wafers 24a to 24f are indirectly heated.

Each of the heaters vertically rotates around each of not-illustrated rotary shafts parallel with each of the wafer mounting surfaces 23a to 23f of the susceptors 22a to 22f. Therefore, each of the susceptors 22a to 22f can easily be detached in a space formed above each of the susceptors 22a to 22f by turning each of the heaters upward.

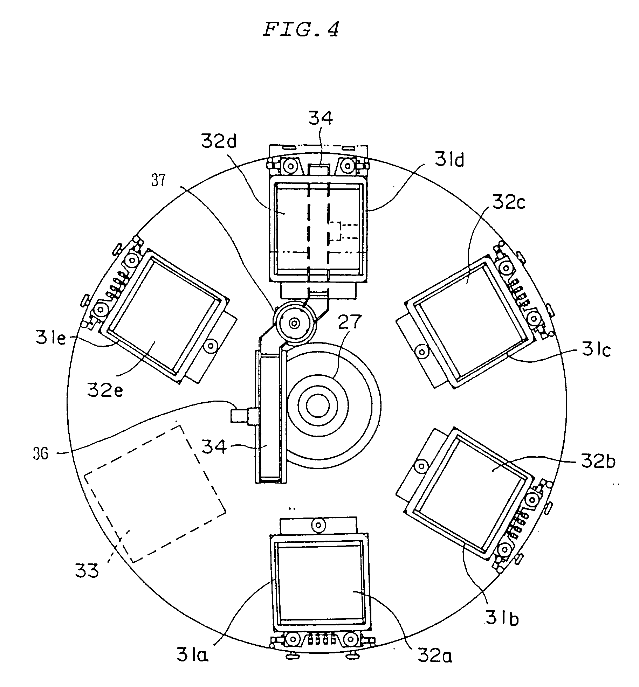

In Fig. 2 and Fig. 4, symbol 30 is a gas distributor for supplying a reaction gas to the wafers 24a to 24f, on which gas dischargers 31a to 31e separated from each other are set along the circumference around the rotary shaft 27 at five places at intervals corresponding to the susceptors 22a to 22f. There is one portion where no gas discharger is set, which serves as a loading/unloading portion 33.

A used or unnecessary reaction gas is exhausted through an exhaust port around each of the gas dischargers 31a to 31e.

The gas discharge surfaces 32a to 32e of the gas dischargers 31a to 31e are turned upward so as to face the wafer mounting surfaces 23a to 23f of the susceptors 22a to 22f.

Symbol 34 is a cleaner for removing reaction products sticking to the gas discharge surfaces 32a to 32e. The cleaner 34 is supported by a rotary shaft 37. The rotary shaft 37 is rotated to move it to a saved portion close to the rotary shaft 27 of the wafer holder 21 when it is not worked and move it onto the gas discharge surfaces 32a to 32e when it is worked. The rotary shaft 37 is formed integrally with the wafer holder 21 and the cleaner 34 rotates together with the wafer holder 21 according to the rotation of the wafer holder 21.

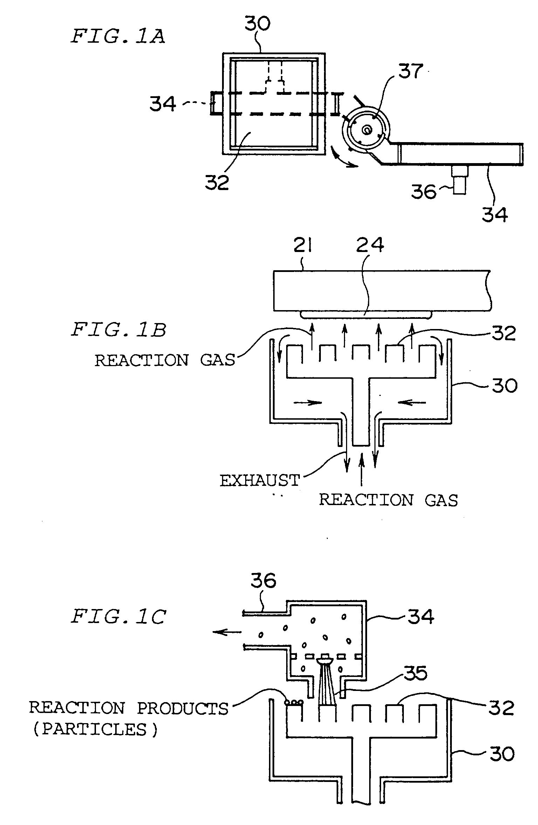

Moreover, as shown in Fig. 1 C in detail, the cleaner 34 has a brush 35 protruding to a surface of a slender angular vessel which faces and cotacts the gas discharge surfaces 32a to 32e. Furthermore, the surface mounting the brush 35 has an opening which connects with a suction port 36 provided at the side of the vessel. The suction port 36 connects with a not-illustrated exhauster and by exhausting gas immediately draws in dust having come off from the gas discharge surface 32a to 32e by brushing them with the brush 35.

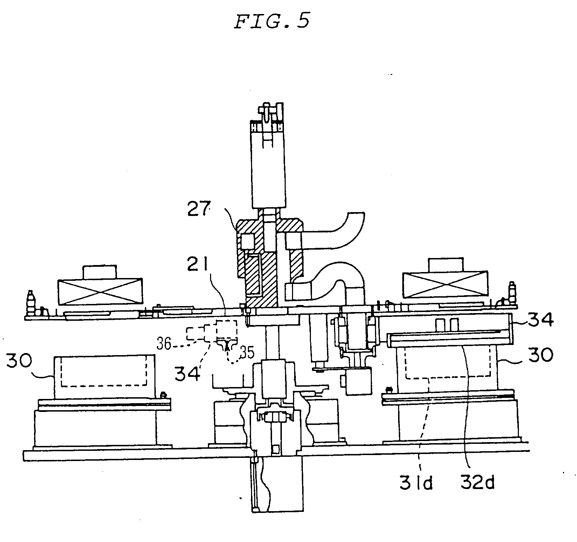

In the case of cleaning the gas discharge surfaces 32a to 32e, after forming a film on a wafer inthe state of making the wafer holder 21 approach the gas discherge surface 32a to 32e and facing the wafer holder 21 with the gas distributor 30 as shown in Fig. 1 B in detail, the wafer holder 21 is moved upward by raising the rotary shaft 27 by which the wafer holder 21 is supported so that a space is formed between the wafer holder 21 and the gas distributor 30. Accordingly, the cleaner 34 is not interrupted to come on the gas discharge surfaces 32a to 32e of the gas distributor 30 by rotating as shown in Fig. 5. Then, the cleaner 34 is moved on the gas discharge surfaces 32a to 32e and contacts and rubs them through the brush 35.

As described above, the CVD apparatus of the embodiment of the present invention has the cleaner 34 comprising the suction port 36 and the brush 35 formed at the entrance of the suction port 36. And also the cleaner 34 is supported by the rotary shaft 37 capable of going and returning the cleaner 34 by rotating it between the gas discharge surfaces 32a to 32e and the saved portion. Then, the brush 35 of the cleaner 34 having come on the gas discharge surfaces 32a to 32e contacts the gas discharge surfaces 32a to 32e.

Therefore, by brushing the gas discharge surfaces 32a to 32e with the brush 35 while exhausting gas through the suction port 36 by exhauster, it is possible to make reaction products come off and draw in the dust having come off through the suction port 36 before or after forming a film. Thereby, the gas discharge surfaces 32a to 32e is kept clean and the dust is prevented from scattering in the chamber, whereby a higher cleanliness in the chamber is realized.

The cleaner 34 is provided at a mechanical section which is separated from the wafer holder 21 and gas distributor 30.

Therefore, because it is possible to leave the cleaner 34 as it is when separating the susceptors 22a to 22f or gas dischargers 31a to 31e for cleaning or repair and, on the contrary, it is possible to leave the susceptors 22a to 22f or gas dischargers 31a to 31e as they are when separating the cleaner 34. Thereby, a maintenance of the apparatus can easily be performed.

Moreover, the cleaner 34 is set in a chamber where the gas distributor 30 and the wafer holder 21 is supported by the rotary shaft 27 are provided. Therefore, it is possible to provide such an automated and continuous type of a CVD apparatus capable of keeping the chamber clean at all times. Moreover, because the wafer holder 21 is formed integrally with the rotary shaft 37, it is possible to move the cleaner 34 onto all the gas dischargers 31a to 31e according to the rotation of the wafer holder 21.

Besides, for the embodiment, the wafer holder 21 is supported by the rotary shaft 27 and rotated. However, it is also possible to fix the wafer holder 21 and support the gas distributor 30 with the rotary shaft 27 to rotate and move the gas distributor 30. In this case, a space for rotating the cleaner 34 is formed by moving the rotary shaft 27 upward through using the rotary shaft 27 of the gas distributor 30 as moving means.

Moreover, the gas distributor 30 is set under the wafer holder 21 and the heaters 28a and 28d are set on the holder, and a film is formed with the deposition surface of a wafer turned downward.

It is also possible to form a film on the deposition surface of the wafer turned upward by setting the gas distributor on the wafer holder and the heaters under the holder.

Though the wafer holder 21 is separated from the heaters 28a and 28d for the above embodiment, it is possible to form the holder integrally with the heaters for another way.

### (2) Description of method for cleaning gas discharger

A method for cleaning the gas dischargers 31a to 31e with the cleaner 34 is described below by referring to Fig. 1 A to Fig. 1 C and Fig. 4 and Fig. 5.

When forming a film on a wafer by the CVD method, reaction products are sticking to the gas discharge surfaces 32a to 32e of a gas distributor in which a reaction gas circulates. When leaving the reaction products as they are, they come off and transform into particles and stick to a wafer to prevent patterning or cause a film to abnormally form. Therefore, it is necessary to regularly clean the gas discharge surfaces 32a to 32e of the gas dischargers 31a to 31e by using the cleaner 34.

When cleaning the gas discharge surfaces 32a to 32e of the gas dischargers 31a to 31e by using the cleaner 34, the rotary shaft 27 by which the wafer holder 21 is supported is moved upward to form a space in which the cleaner 34 can move between the wafer holder 21 and gas dischargers 31a to 31e as shown in Fig. 5, and then the cleaner 34 close to the rotary shaft 27 is rotated clockwise around the rotary shaft 37 to move the cleaner onto the gas discharge surface 32d and contact the brush 35 with the gas discharge surface 32d as shown in Fig. 1 A and Fig. 4.

After cleaning the gas discharge surface 32d, the cleaner is reciprocated right and left so as to cover the whole gas discharge surface 32d while exhausting gas through the suction port. Thereby, as shown in Fig. 1 C, reaction products are removed by the brush 35, drawn in by the cleaner 34 without scattering around and discharged to the outside of the CVD apparatus.

Then, the rotary shaft 27 is rotated to move the cleaner 34 and thereafter the gas discharge surface 32c is cleaned in the same way as the above. Thus, remaining gas discharge surfaces 32b, 32a, and 32e are successively cleaned and resultingly all the gas discharge surfaces 32a to 32e are cleaned. In this case, because removed dust is immediately drawn in, the inside of the CVD apparatus is not contaminated and kept clean.

As described above, when cleaning the gas discharge surfaces 32a to 32e of the CVD apparatus of the embodiment of the present invention, it is possible to remove dust sticking to the gas discharge surfaces 32a to 32e and prevent the dust from scattering in a chamber by brushing the gas discharge surfaces 32a to 32e with the brush 35 and drawing in the dust removed from the gas discharge surfaces 32a to 32e before or after forming a film, and thus realize higher cleanliness in the chamber.

Moreover, because the cleaner 34 is provided in the chamber, it is possible to easily remove dust from the chamber without opening the chamber. Therefore, because it is unnecessary to stop a operation of the apparatus, it is possible to prevent the working ratio of the apparatus from decreasing unlike the existing way.

### (3) Description of the method for forming film using CVD apparatus of the embodiment of the present invention

A method for forming a two-layer insulating film on a wafer by using the CVD apparatus having the gas distributor 30 and wafer holder 21 shown in Fig. 2 are described below by referring to Fig. 2 to Fig. 4 and Fig. 6 C. In this case, as shown in Fig. 6 C, a two-layer film made of a CVDSiO₂ film and a PSG film of which each has a predetermined thickness are formed on the wafers 24a to 24f while the wafer holder 21 makes a round of the rotary shaft 27. In Fig. 6 C, symbol A represents a predetermined thickness of the CVDSiO₂ film formed on the wafers 24a to 24f and B represents a predetermined thickness of the PSG film.

First, the first wafer 24a is transferred underneath the susceptor 22a located at the loading/unloading portion 33 from a not-illustrated cassette station by a robot.

Then, the first wafer 24a is contacted to the wafer mounting surface 23a of the susceptor 22a, air is exhausted through the exhaust port/gas introduction port 25a, and a not-illustrated solenoid valve is opened to secure the first wafer 24a to the wafer mounting surface 23a by suction. Then, electric power is supplied to all heaters 28a to 28f to heat all susceptors 22a to 22f and keep the temperature of all wafer mounting surfaces 23a to 23f at approx. 350°C.

Then, after the temperature of the first wafer 24a reaches approx. 350°C, the rotary shaft 27 is rotated counterclockwise and the rotation is stopped when the susceptor 22a comes to a position just above the gas discharger 31a. In this case, because the moving time is as short as approx. 0.8 sec and the susceptor 22a has a large heat capacity, the temperature of the first wafer 24a hardly lowers during the moving period.

Then, a mixture gas of TEOS-O₃ is discharged from the gas discharger 31a as a reaction gas. In this case, the deposition rate of a SiO₂ film comes to approx. 2,000 Å. After approx. 1 min, an SiO₂ film with a thickness of approx. 2,000 Å which is approx. 1/2 the predetermined thickness is formed on the first wafer 24a. While the film is formed, the reaction gas is uniformly supplied onto the first wafer 24a because the susceptor 22a performs a linear reciprocative motion by a not-illustrated oscillation unit in the radial direction around the position where it is held. Thereby, the thickness of the formed SiO₂ film is uniformed and the film quality is improved.

During the above period, the second wafer 24b is mounted on the susceptor 22b located at the loading/unloading portion 33 and the temperature of the second wafer 24b is kept at approx. 350°C, similarly to the above mentioned.

Then, the rotary shaft 27 is rotated and the rotation is stopped when the susceptors 22b and 22a come to positions just above the gas dischargers 31a and 31b respectively. In this case, it is possible to immediately start forming a film because the temperature of the second wafer 24b already reaches approx. 350°C. Therefore, the TEOS-O₃ mixture gas is immediately discharged from the gas dischargers 31a and 31b as a reaction gas. When this state is kept for approx. 1 min, an SiO₂ film with a thickness of approx. 4,000 Å which is the predetermined thickness is formed on the first wafer 24a and an SiO₂ film with a thickness of approx. 2,000 Å which is approx. 1/2 the predetermined thickness is formed on the second wafer 24b.

During the above period, the third wafer 24c is mounted on the susceptor 22c located at the loading/unloading portion 33a and the temperature of the third wafer 24c is kept at approx. 350°C, similarly to the above mentioned.

Then, the rotary shaft 27 is rotated and the rotation is stopped when the susceptors 22c, 22b, and 22a come to positions just above the gas dischargers 31a, 31b, and 31c respectively. At this time, it is possible to immediately start forming a film because the temperature of the third wafer 24c already reaches approx. 350°C. Therefore, a mixture gas of TEOS-O₃ and TMPO is immediately discharged from the gas dischargers 31a, 31b, and 31c as a reaction gas. When this state is kept for approx. 1 min, a PSG film with a thickness of approx. 2,000 Å which is approx. 1/3 the predetermined thickness is formed on the first wafer 24a, an SiO₂ film with a thickness of approx. 4,000 Å which is the predetermined thickness is formed on the second wafer 24b, and moreover, an SiO₂ film with a thickness of 2,000 Å which is approx. 1/2 the predetermined thickness is formed on the third wafer 24c.

Thus, wafers are set to the susceptors 22d to 22f to send them one by one and form a two-layer insulating film made of both an SiO₂ film and PSG film on each wafer. When the first wafer 24a makes a round of the rotary shaft 27 and returns to the loading/unloading portion 33, the SiO₂ film and the PSG film with the predetermined thickness are formed on the first wafer 24a. During the above period, the wafer temperature for forming a film is very stable.

When a robot is moved to the loading/unloading portion 33, a solenoid valve for operating the vacuum chuck of the susceptor 22a is closed, and a not-illustrated nitrogen-introduction valve is opened to supply nitrogen gas to the vacuum chuck, the first wafer 24a is held by the robot and detached from the wafer mounting surface 23a. Then, the first wafer 24a is transferred to a cooling chamber on the cassette station by the robot. The first wafer 24a transferred to the cooling chamber is air-cooled by blowing nitrogen gas on it and housed in a wafer cassette. Thus, an SiO₂ film and a PSG film of which each has a predetermined thickness are successively formed on wafers and the wafers are accumulated in the wafer cassette.

As described above, the method for forming a SiO₂ film using the CVD apparatus of the embodiment makes it possible to keep a high throughput because the loading/unloading time is not explicitly added.

Moreover, by setting the susceptors 22a to 22f and the dischargers 31a to 31e separately from each other, it is possible to accurately control the production of each wafer.

Furthermore, because each of the susceptors 22a to 22f performs a linear reciprocative motion in the radial direction around the position where each of them is held, a reaction gas is uniformly supplied to wafers.

Though the heaters 28a to 28f are separated from the wafer holder 21 and moving wafers go away from the heaters 28a to 28f, the wafer temperature hardly fluctuates because the wafer mounting table 47 has a large heat capacity and completes movement in a short time. Thereby, it is possible to form a film with a uniform thickness and a high quality on wafers.

For the above method for manufacturing the semiconductor device, a two-layer insulating film is formed by using two types of reaction gases. However, as shown in Fig. 6 A, it is also possible to form a single film on the wafer 241 while the wafer 241 makes a round by supplying one type of gas to the gas dischargers 31a to 31e.

Moreover, as shown in Fig. 6 B, it is possible to form a single film by a method similar to the batch system by previously setting wafers 24g to 24k to all the susceptors 22a to 22f and thereafter forming a film on the wafers 24g to 24k at the same time by using one type of reaction gas.

## Claims

1. An apparatus for forming a film onto a wafer comprising:
a gas distributor (30) having a horizontal gas discharge surface (32) from which a reaction gas for forming a film on a substrate (24) is discharged;
a wafer holder (21) for holding said wafer and having a wafer mounting surface facing the gas discharge surface (32);
a cleaner (34) having a suction port (36) and a brush (35) formed at the entrance of the suction port (36);
a vertical rotary shaft (37) for supporting the cleaner (34) to reciprocate the cleaner (34) between the gas discharge surface (32) and a rest position, so that the brush (35) of the cleaner (34) can contact the gas discharge surface (32);
characterized by
moving means for moving the wafer holder (21) or gas distributor (30) upwardly or downwardly, so that the wafer holder (21) approaches the gas discharge surface (32) when forming a film, and is kept away from the gas discharge surface (32) when cleaning the gas discharge surface (32) upon moving the cleaner (34) on the gas discharge surface (32).

2. The apparatus for forming a film according to claim 1, further comprising a rotary shaft (27) which supports the wafer holder (21) to rotate and move the wafer holder (21) therearound while the gas discharge surface (32) and the wafer mounting surface face each other.

3. The apparatus for forming a film according to claim 1 or 2, wherein the wafer holder (21) is provided with a plurality of wafer mounting surfaces (23a to 23f) arranged in a circle around the rotary shaft (27), at least one of said wafer mounting surfaces (23a to 23f) facing the gas discharge surface (32).

4. The apparatus for forming a film according to claim 3, wherein the gas discharge surface (32) is separated into a plurality of gas discharge surfaces (32a to 32e), said gas discharge surfaces (32a to 32e) being arranged in a circle around the rotary shaft (27).

5. The apparatus for forming a film according to one of claims 1 to 4 wherein the rotary shaft (27) of the wafer holder (21) serves as the moving means.

6. The apparatus for forming a film according to claim 2, wherein the rotary shaft (37) supporting the cleaner (34) is formed integrally with the wafer holder (21) and the cleaner (34) rotates together with the wafer holder (21) according to the rotation of the wafer holder (21).

7. The apparatus for forming a film according to one of claims 1 to 6, further comprising a rotary shaft which supports the gas distributor (30) therearound while the gas discharge surface (32) and the wafer mounting surface face each other.

8. The apparatus for forming a film according to claim 7, wherein the wafer holder is provided with a plurality of wafer monting surfaces arranged in a circle around the rotary shaft, at least one of said wafer mounting surfaces facing the gas discharge surface (32).

9. The apparatus for forming a film according to claim 8, wherein the gas discharge surface (32) is separated into a plurality of gas discharge surfaces, said gas discharge surfaces being arranged in a circle around the rotary shaft.

10. The apparatus for forming a film according to one of claims 7 to 9, wherein the rotary shaft of the gas distributor (30) also serves as the moving means.

11. The apparatus for forming a film according to claim 7, wherein the gas distributor (30) is supported by the rotary shaft (27).

## Patentansprüche

1. Vorrichtung zum Ausbilden eines Films auf einem Wafer, umfassend:
einen Gasverteiler (30) mit einer horizontalen Gasfreisetzungsfläche (32), von der ein Reaktionsgas zum Ausbilden eines Films auf einer Unterlage (24) freigesetzt wird;
einen Waferhalter (21) zum Halten des Wafers, der eine Waferhaltefläche aufweist, die auf die Gasfreisetzungsfläche (32) gerichtet ist;
einen Reiniger (34) mit einer Saugöffnung (36) und einer Bürste (35), die am Eingang der Saugöffnung (36) ausgebildet ist;
eine vertikale Drehwelle (37) zum Halten des Reiniger (34), um den Reiniger (34) zwischen der Gasfreisetzungsfläche (32) und einer Ruhelage hin und her zu bewegen, so daß die Bürste (35) des Reinigers (43) die Gasfreisetzungsfläche (32) berühren kann;
**gekennzeichnet durch**
eine Bewegungseinrichtung zum Bewegen des Waferhalters (21) oder des Gasverteilers (30) nach oben oder nach unten, so daß sich der Waferhalter (21) der Gasfreisetzungsfläche (32) nähert, wenn ein Film ausgebildet wird und so daß er von der Gasfreisetzungsfläche (32) ferngehalten wird, wenn die Gasfreisetzungsfläche (32) durch Bewegen des Reinigers (34) auf der Gasfreisetzungsfläche (32) gereinigt wird.

2. Vorrichtung zum Ausbilden eines Films gemäß Anspruch 1, weiter umfassend eine Drehwelle (27), die den Waferhalter (21) hält und diesen Waferhalter (21) dreht und darum herum bewegt, während die Gasfreisetzungsfläche (32) und die Waferhaltefläche aufeinander gerichtet sind.

3. Vorrichtung zum Ausbilden eines Films nach Anspruch 1 oder 2, bei dem der Waferhalter (21) mit mehreren Waferhalteflächen (23a bis 23f) versehen ist, die im Kreis um die Drehwelle (27) herum angeordnet sind, wobei zumindest eine der Waferhalteflächen (23a bis 23f) der Gasfreisetzungsfläche (32) gegenüberliegt.

4. Vorrichtung zum Ausbilden eines Films nach Anspruch 3, bei der die Gasfreisetzungsfläche (32) in mehrere Gasfreisetzungsflächen (32a bis 32e) geteilt ist, wobei die Gasfreisetzungsflächen (32a bis 32e) im Kreis um die Drehwelle (27) herum angeordnet sind.

5. Vorrichtung zum Ausbilden eines Films nach einem der Ansprüche 1 bis 4, bei dem die Drehwelle (27) des Waferhalters (21) als Bewegungseinrichtung dient.

6. Vorrichtung zum Ausbilden eines Films nach Anspruch 2, bei der die den Reiniger (34) haltende Drehwelle (37) einstückig mit dem Waferhalter (21) ausgebildet ist und bei der sich der Reiniger (34) zusammen mit dem Waferhalter (21) in Abhängigkeit von der Drehung des Waferhalters (21) dreht.

7. Vorrichtung zum Ausbilden eines Films nach einem der Ansprüche 1 bis 6, weiter umfassend eine Drehwelle, die den Gasverteiler (30) darum herum hält, während die Gasfreisetzungsfläche (32) und die Waferhaltefläche aufeinander gerichtet sind.

8. Vorrichtung zum Ausbilden eines Films nach Anspruch 7, bei dem der Waferhalter mit mehreren Waferhalteflächen versehen ist, die im Kreis um die Drehwelle herum angeordnet sind, wobei zumindest eine der Waferhalteflächen auf die Gasfreisetzungsfläche (32) gerichtet ist.

9. Vorrichtung zum Ausbilden eines Films gemäß Anspruch 8, bei der Gasfreisetzungsfläche (32) in mehrere Gasfreisetzungsflächen unterteilt ist, wobei die Gasfreisetzungsflächen im Kreis um die Drehwelle herum angeordnet sind.

10. Vorrichtung zum Ausbilden eines Films nach einem der Ansprüche 7 bis 9, wobei die Drehwelle des Gasverteilers (30) auch als Bewegungseinrichtung dient.

11. Vorrichtung zum Ausbilden eines Films nach Anspruch 7, bei der der Gasverteiler (30) von der Drehwelle (27) gehalten wird.

## Revendications

1. Appareil pour former un film sur une tranche comportant :
un distributeur de gaz (30) ayant une surface horizontale (32) de décharge de gaz à partir de laquelle est déchargé un gaz de réaction destiné à former un film sur un substrat (24);
un support de tranche (21) destiné à supporter ladite tranche et ayant une surface de montage de tranche située vis-à-vis de la surface de décharge de gaz (32);
un élément de nettoyage (34) ayant un orifice d'aspiration (36) et un balai (35) formé au niveau de l'entrée de l'orifice d'aspiration (36);
un arbre rotatif vertical (37) destiné à supporter l'élément de nettoyage (34) pour déplacer alternativement l'élément de nettoyage (34) entre la surface de décharge de gaz (32) et une position de repos, de sorte que le balai (35) de l'élément de nettoyage (34) puisse venir en contact avec la surface de décharge de gaz (32),
caractérisé en ce qu'il comporte
des moyens de déplacement pour déplacer le support de tranche (21) ou le distributeur de gaz (30) vers le haut ou vers le bas, de manière à ce que le support de tranche (21) soit rapproché de la surface de décharge de gaz (32) lors de la formation d'un film, et soit maintenu à distance de la surface de décharge de gaz (32) lors du nettoyage de la surface de gaz (32) par déplacement de l'élément de nettoyage (34) sur la surface de décharge de gaz (32).

2. Appareil pour former un film selon la revendication 1, comportant en outre un arbre rotatif (27) qui supporte le support de tranche (21) de manière à faire tourner et à déplacer le support de tranche (21) autour de celui-ci, la surface de décharge de gaz (32) et la surface de montage de tranche étant situées en vis-à-vis l'une de l'autre.

3. Appareil pour former un film selon la revendication 1 ou 2, dans lequel le support de tranche (21) comporte plusieurs surfaces de montage de tranche (23a à 23f) agencées en formant un cercle autour de l'arbre rotatif (27), au moins l'une desdites surfaces de montage de tranche (23a à 23f) étant située en vis-à-vis de la surface de décharge de gaz (32).

4. Appareil pour former un film selon la revendication 3, dans lequel la surface de décharge de gaz (32) est séparée en plusieurs surfaces de décharge de gaz (32a à 32e), lesdites surfaces de décharge de gaz (32a à 32e) étant agencées en formant un cercle autour de l'arbre rotatif (27).

5. Appareil pour former un film selon l'une quelconque des revendications 1 à 4, dans lequel l'arbre rotatif (27) du support de tranche (21) sert en tant que moyens de déplacement.

6. Appareil pour former un film selon la revendication 2, dans lequel l'arbre rotatif (37) supportant l'élément de nettoyage (34) est formé d'un bloc avec le support de tranche (21), et l'élément de nettoyage (34) tourne en association avec le support de tranche (21) conformément à la rotation du support de tranche (21)

7. Appareil pour former un film selon l'une quelconque des revendications 1 à 6, comportant en outre un arbre rotatif qui supporte le distributeur de gaz (30) autour de celui-ci, la surface de décharge de gaz (32) et la surface de montage de tranche étant situées en vis-à-vis l'une de l'autre.

8. Appareil pour former un film selon la revendication 7, dans lequel le support de tranche comporte plusieurs surfaces de montage de tranche agencées en formant un cercle autour de l'arbre rotatif, au moins l'une desdites surfaces de montage de tranche étant située en vis-à-vis de la surface de décharge de gaz (32).

9. Appareil pour former un film selon la revendicaton 8, dans lequel la surface de décharge de gaz (32) est séparée en plusieurs surfaces de décharge de gaz, lesdites surfaces de décharge de gaz étant agencées en formant un cercle autour de l'arbre rotatif.

10. Appareil pour former un film selon l'une quelconque des revendications 7 à 9, dans lequel l'arbre rotatif du distributeur de gaz (30) sert aussi en tant que moyens de déplacement.

11. Appareil pour former un film selon la revendication 7, dans lequel le distributeur de gaz (30) est surpporté par l'arbre rotatif (27).
